(19) Europäisches Patentamt
European Patent Office
Office européen des brevets

(11) Veröffentlichungsnummer: **0 087 151**
**A2**

(12) # EUROPÄISCHE PATENTANMELDUNG

(21) Anmeldenummer: **83101649.8**

(22) Anmeldetag: **21.02.83**

(51) Int. Cl.$^3$: **C 23 C 11/00**

(30) Priorität: **23.02.82 DE 3206421**

(43) Veröffentlichungstag der Anmeldung:
**31.08.83 Patentblatt 83/35**

(84) Benannte Vertragsstaaten:
**AT CH FR GB LI NL**

(71) Anmelder: **SIEMENS AKTIENGESELLSCHAFT**
**Berlin und München Wittelsbacherplatz 2**
**D-8000 München 2(DE)**

(72) Erfinder: **Wieczorek, Claudia, Ing. grad.**
**Ostpreussenstrasse 2**
**D-8012 Ottobrunn(DE)**

(54) **Verfahren zum Herstellen von Schichten aus hochschmelzenden Metallen bzw. Metallverbindungen durch Abscheidung aus der Dampfphase.**

(57) Die Erfindung betrifft ein Verfahren zum Herstellen von Schichten (8) aus hochschmelzenden Metallen bzw. Metallverbindungen durch Abscheidung aus der Dampfphase, bei dem die gasförmigen Ausgangsmaterialien (1) in einer Glimmentladung (9) zersetzt und bei niedriger Substrattemperatur und vermindertem Druck niedergeschlagen werden. Erfindungsgemäß wird die Glimmentladung durch induktive Einkopplung von Hochfrequenzenergie (5) erzeugt, wobei das Plasma so eingestellt wird, daß das zu beschichtende Substrat (7) im Bereich des Kathodenglimmlichts (9) liegt. Das Verfahren wird verwendet zur Herstellung von beispielsweise Mehrlagenverdrahtungen bei integrierten Halbleiterschaltungen, von Dünnschichtbauelementen und zur Metallisierung von Kunststoffteilen.

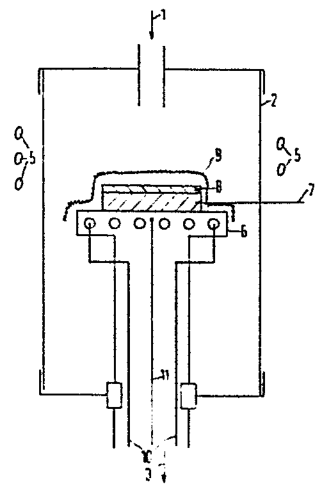

EP 0 087 151 A2

SIEMENS AKTIENGESELLSCHAFT
Berlin und München



Unser Zeichen
VPA 82 P 1119 E

Verfahren zum Herstellen von Schichten aus hochschmelzenden Metallen bzw. Metallverbindungen durch Abscheidung aus der Dampfphase.

Die vorliegende Patentanmeldung betrifft ein Verfahren zum Herstellen von Schichten aus hochschmelzenden Metallen bzw. Metallverbindungen, wie sie insbesondere für elektronische Bauelemente und -schaltungen verwendet werden, durch Abscheidung der Metalle bzw. der Metallverbindungen aus der Dampfphase, bei dem das Metall- oder die Metallverbindung durch Glimmentladung in einer, die gasförmige Metallverbindung enthaltenden Atmosphäre bei vermindertem Druck zersetzt und bei niedriger Substrattemperatur auf einem gegen die Reaktionsgase inerten Substrat niedergeschlagen wird.

In der Dünnschicht- und Halbleitertechnik werden metallische Schichten als Widerstände, Elektroden für Kondensatoren und als Induktivitäten, auf strukturierten Halbleiterkristallscheiben als Leiterbahnen verwendet. Außerdem werden Metallbeschichtungen auch als Korrosions- und Verschleißschutz bei kompliziert geformten Werkstücken verwendet.

Für die Herstellung solcher Schichten kommen die unterschiedlichsten Verfahren, wie z. B. die galvanische Abscheidung, das Aufdampfen, das Ionenplattieren oder auch das Aufstäuben zum Einsatz. All diesen Methoden der Schichtgewinnung ist gemeinsam, daß das Material im Vergleich zu seinem Schmelzpunkt bei niedrigen Temperaturen (max. 350°C) und bei der Galvanik in Anwesenheit von Fremdatomen abgeschieden wird. Niedrige Temperaturen

Edt 1 Plr/18.2.1982

BAD ORIGINAL

sind beispielsweise möglich bei der galvanischen Abscheidung. Diese Art der Abscheidung ist aber bei hochschmelzenden Metallen, wie Tantal, Wolfram und Molybdän nicht durchführbar, da sich diese Metalle galvanisch nicht abscheiden lassen.

Wichtig bei der Schichtherstellung auf strukturierten Halbleiterkristallscheiben ist die Kantenbedeckung. Mit Hilfe des CVD (chemical vapor deposition)-Verfahrens läßt sich zwar eine ausgezeichnete Kantenbedeckung erreichen, was vor allem für die VLSI (very large scale integration)-Technik, bei der unter anderem höhere Stromdichten in den Leiterbahnen auftreten, von großer Bedeutung ist, doch ist die Abscheidung für hochschmelzende Metalle, wie Niob und Tantal nur bei hohen Temperaturen möglich, was bei einer Mehrlagenverdrahtung wegen der Empfindlichkeit der bereits hergestellten Bauelemente nicht durchführbar ist. So führt eine lokale Verringerung der Schichtdicke bei Stromdurchgang zu einem unerlaubt hohen Temperaturanstieg an solchen Stellen (hot spots), was vorzeitige Ausfälle durch Elektro- und Thermomigration zur Folge hat.

Bisher führen die beim CVD-Verfahren zum Teil notwendigen hohen Temperaturen zu einer Einschränkung des Anwendungsbereiches dieser Methode. Bei bereits strukturierten IC-Scheiben (Mehrlagenverdrahtung) sowie bei niedrig schmelzenden Werkstoffen und Kunststoffen muß aufgrund der zu hohen Beschichtungstemperaturen derzeit auf das CVD-Verfahren verzichtet werden.

Zum Beschichten ebener Substrate bei niedriger Temperatur werden derzeit Verfahren wie das Aufdampfen und Aufstäuben eingesetzt. Da besonders im Hinblick auf die VLSI-Technik eine bessere Kantenbedeckung notwendig wird, arbeitet man bei den physikalischen Beschichtungsverfahren (Aufdampfen, Aufstäuben) mit Probenhalterungen, die eine Planetenbewegung durchführen.

BAD ORIGINAL

Beim CVD-Verfahren, welches eine sehr gute Kantenbedeckung liefert, sind die Modifikationen von Interesse, bei denen die Abscheidung bei erniedrigter Substrattemperatur durchgeführt werden kann. Es werden für solche Beschichtungen modifizierte CVD-Verfahren vorgeschlagen, bei denen die Reaktionstemperaturen entweder durch den Einsatz metallorganischer Ausgangsverbindungen (Carbonyle oder Acetylacetonate) oder durch Anwendung eines Hochfrequenzplasmas als Energiequelle erniedrigt werden. Durch die Verwendung metallorganischer Ausgangsverbindungen (siehe Science and Technology of Surface Coatings, Academic Press, London and New York (1974) Seiten 159 bis 168) lassen sich Metalle und deren Verbindungen, wie Oxide, Nitride und Carbide herstellen, jedoch werden hier, bedingt durch die organische Komponente, Verunreinigungen beim Beschichten miteingebaut.

Bei der Anwendung eines Hochfrequenzplasmas als Energiequelle, wie in der europäischen Patentanmeldung 00 34 706 beschrieben, wird durch Anlegen einer Hochfrequenz (kHz ... MHz-Bereich) bei niedrigen Reaktionsdrucken (kleiner $1{,}3 \times 10^3$ Pa) ein Plasma erzeugt, welches in der Lage ist, auch stärkere chemische Bindungen aufzubrechen. Auf diese Weise werden derzeit z. B. amorphes Silizium für Solarzellen sowie dessen Verbindungen Siliziumoxid, Siliziumnitrid usw. hergestellt.

Eine weitere Möglichkeit der Beschichtung mit hochschmelzenden Metallen bei niedrigeren Substrattemperaturen wird in der deutschen Patentanmeldung P 31 41 567.9 vorgeschlagen. Hier werden Ausgangsverbindungen mit großer Affinitätswechselwirkung für die Beschichtung verwendet.

Die Aufgabe, die der vorliegenden Erfindung zugrundeliegt, besteht in der Herstellung von hochschmelzenden reinen Metallschichten, wie sie insbesondere für eine Mehrlagen-

BAD ORIGINAL

verdrahtung auf strukturierten Halbleiterkristallscheiben verwendet werden. Dabei soll wegen der guten Kantenbedeckung ein CVD-Verfahren bei niedrigen Substrattemperaturen anwendbar sein und die Beschichtung auf Substraten mit unterschiedlichen Materialeigenschaften bzw. verschiedenartig zusammengesetzten Oberflächenbereichen möglich sein.

Diese Aufgabe wird durch ein Verfahren der eingangs genannten Art dadurch gelöst, daß die Glimmentladung durch induktive Einkopplung von Hochfrequenzenergie erzeugt wird, wobei das Plasma so eingestellt wird, daß das zu beschichtende Substrat im Bereich des Kathodenglimmlichts liegt.

In einer Weiterbildung des Erfindungsgedankens ist vorgesehen, die Frequenz im Bereich zwischen 0,4 bis 14 MHz, die Leistung des HF-Generators auf einen Bereich zwischen 0,5 bis 5 kW einzustellen, wobei das Substrat auf einem Potential zwischen -100 V und +50 V liegt. Desweiteren ist vorgesehen, die Substrattemperatur während der Abscheidung im Bereich zwischen 200 und 450°C und den Druck im Bereich von 60 bis 1350 Pa zu halten. Da die für die Zersetzung der Ausgangsverbindung notwendige Energie zum größten Teil aus dem elektrischen Wechselfeld bezogen wird, kann die Substrattemperatur z. B. bei der Reduktion von Metallhalogeniden auf ca. 400°C reduziert werden. Damit wird es erstmals möglich, auch reinste Schichten hochschmelzender Metalle auf strukturierten Siliziumscheiben mit Hilfe des CVD-Verfahrens abzuscheiden, ohne daß die elektrischen Eigenschaften der Bauelemente durch thermischen Einfluß verändert werden.

Als wesentlicher Vorteil im Vergleich zu dem bekannten Aufstäuben von z. B. Aluminium/Silizium gilt die bessere Kantenbedeckung des plasmaaktivierten CVD-Verfahrens. Dieser Vorteil wird bei Mehrlagenverdrahtungen, wo

BAD ORIGINAL

Stufenhöhen von mehreren µm auftreten, besonders wirksam. Da sich mit diesem Verfahren neben Aluminium oder Gold auch niederohmige, hochschmelzende Metalle abscheiden lassen (z. B. Molybdän, Wolfram, Niob, Tantal), stehen für die Metallisierung Materialien zur Verfügung, die durch die zu erwartenden höheren Stromdichten in der VLSI-Technik nicht zerstört werden (z. B. durch Elektromigration).

Eine Metallisierung nach dem erfindungsgemäßen Prinzip, z. B. ausgehend von einem Metallhalogenid (MeX), läuft auf folgende Weise ab:

$$MeX_{(gas)} + H_{2\,(gas)} \xrightarrow{\text{HF-Plasma}} \cdots \xrightarrow{T<450\,^{\circ}C} Me_{(fest)} + HX_{(gas)} + \cdots$$

Als Trägergas für die MeX-Komponente kann dabei sowohl $H_2$ als auch ein Inertgas (z. B. Ar, Kr, $N_2$...) dienen. Im Reaktionsraum wird durch induktive Einkopplung ein Plasma so eingestellt, daß die zu beschichtende Probe von einem leuchtenden Saum umgeben ist. Die induktive Einkopplung der Hochfrequenz bringt ferner den Vorteil, daß das Plasma elektrodenfrei erzeugt wird. Damit werden Verunreinigungen durch Elektrodenmaterialien, wie sie beispielsweise bei einer kapazitiven Einkopplung möglich sind, vollkommen ausgeschlossen. Die Erwärmung des Substrats kann direkt durch die Hochfrequenzspule sowie durch eine zusätzliche Heizung erfolgen.

Neben der Herstellung des reinen Metalles, z. B. ausgehend von Metallhalogenid (MeX), ist auch mit geeigneten Silizium-Verbindungen eine Abscheidung von Metallverbindungen, wie beispielsweise von Siliziden, z. B. Niobsilizid ($NbSi_2$), möglich:

$$NbCl_{5\,(gas)} + 2\,SiH_2Cl_{2\,(gas)} + 2.5\,H_{2\,(gas)} \xrightarrow{\text{HF-Plasma}} \cdots \xrightarrow{T<450\,^{\circ}C} NbSi_{2\,(fest)} + 9\,HCl_{(gas)}$$

BAD ORIGINAL

Wird der Beschichtungsprozeß wie beschrieben durchgeführt, so wächst auf dem Substrat eine Schicht auf, da der Abtragseffekt durch Wasserstoff-, Halogen- und Metall-Ionen stark reduziert ist. Wider Erwarten ergibt sich eine Abscheidung auch bei Verminderung des Reaktionspartners (z. B. Wasserstoff) bzw. ohne dessen Anteil. Dadurch kann z. B. eine mögliche Versprödung durch Wasserstoff vermieden werden.

Folgende Anwendungsgebiete ergeben sich:

1. Abscheidung von Metallen (z. B. Aluminium, Molybdän, Wolfram, Niob, Tantal).

2. Abscheidung von Metallverbindungen.

3. Einsatz verschiedener Substrate: Silizium, Siliziumoxid, Siliziumnitrid; magnetische empfindliche Werkstoffe; temperaturbeständige Kunststoffe wie Polyimide.

4. Anwendungen außerhalb der Halbleitertechnologie: Leitbahn- und Kontaktmaterial für RC-Netzwerke, Elektrodenschichten auf Dünnschichtdielektrikas, Metallisierung von Kunststoffteilen, Reflektor- und Absorberschichten.

Weitere Einzelheiten sind der in der Zeichnung befindlichen Figur zu entnehmen, welche schematisch eine Vorrichtung zur Durchführung des erfindungsgemäßen Verfahrens darstellt. Die Figur wird anhand eines Ausführungsbeispiels z. B. der Abscheidung von Niobsilizid ($NbSi_2$) beschrieben.

Die für die Herstellung der hochschmelzenden Metallsilizidschicht (3) in der Glimmentladung vorgesehenen gasförmigen, z. B. aus Niobchlorid ($NbCl_5$) und Dichlorsilan ($SiH_2Cl_2$) bestehenden Verbindungen werden an der mit dem Pfeil 1 bezeichneten Stelle in den Reaktor 2 eingeleitet,

BAD ORIGINAL

nachdem dieser vorher auf einen Druck von z. B. 10 Pa evakuiert und das Substrat auf eine Temperatur zwischen 200 bis 450°C erhitzt worden war. Mit dem Pfeil 3 ist der Vakuumpumpenanschluß bezeichnet. Die Saugleistung der Vakuumpumpe wird so eingestellt, daß der Druck des Reaktionsgases im Reaktor im Bereich von 60 bis 1350 Pa liegt. Das beim Pfeil 1 eingeleitete Reaktionsgas, welches auch mit Wasserstoff als Trägergas vermischt sein kann, wird durch eine außerhalb des Reaktors 2 angeordnete Induktionsheizspule 5 durch Glimmentladung zersetzt und auf dem, auf dem geheizten Substrathalter 6 befindlichen Substrat 7, welches beispielsweise aus einer mit Bauelementstrukturen versehenen Siliziumkristallscheibe besteht, als Niobsilizidschicht 8 niedergeschlagen. Im Reaktor 2 wird durch die induktive Einkopplung während der Abscheidung ein Plasma so eingestellt, daß das zu beschichtende Substrat 7 von einem leuchtenden Saum 9 (Kathodenglimmlicht) umgeben ist. Im Falle der Abscheidung von Niobsilizid wird die Frequenz des Generators auf 3 MHz und die Leistung auf 3 kW eingestellt. Das Substrat 7 liegt dabei auf einem Potential von -30 V. Die Erwärmung des Substrats 7 auf 400°C kann durch die HF-Spule 5 sowie auch durch eine zusätzliche Heizung 10 des isoliert in den Reaktor 2 eingeführten Substrathalters 6 erfolgen. Die Beheizung des Substrats 7 wird durch ein Thermoelemente 11 kontrolliert. Der Druck im Reaktor 2 wird während der Abscheidung auf 600 Pa gehalten. Bei einer Substrattemperatur im Bereich von 350 bis 420°C beträgt die Aufwachsrate 8 nm/min. Die Schichtdickenschwankungen, gemessen über ein Substrat vom Durchmesser 75 mm, sind kleiner als 5 %.

10 Patentansprüche
1 Figur

BAD ORIGINAL

Patentansprüche.

1. Verfahren zum Herstellen von Schichten (8) aus hochschmelzenden Metallen bzw. Metallverbindungen, wie sie insbesondere für elektronische Bauelemente und -schaltungen verwendet werden, durch Abscheidung der Metalle bzw. der Metallverbindungen aus der Dampfphase, bei dem das Metall- oder die Metallverbindung durch Glimmentladung in einer, die gasförmige Metallverbindung enthaltenden Atmosphäre (2) bei vermindertem Druck zersetzt und bei niedriger Substrattemperatur auf einem gegen die Reaktionsgase inerten Substrat (7) niedergeschlagen wird, dadurch gekennzeichnet, daß die Glimmentladung durch induktive Einkopplung von Hochfrequenzenergie (5) erzeugt wird, wobei das Plasma so eingestellt wird, daß das zu beschichtende Substrat (7) im Bereich des Kathodenglimmlichts (9) liegt.

2. Verfahren nach Anspruch 1, dadurch gekennzeichnet, daß die Frequenz im Bereich zwischen 0,4 und 14 MHz, die Leistung des HF-Generators auf einen Bereich zwischen 0,5 bis 5 kW eingestellt wird, wobeidas Substrat (7) auf einem Potential zwischen -100 V und +50 V liegt.

3. Verfahren nach Anspruch 1 und 2, dadurch gekennzeichnet, daß die Substrattemperatur während der Abscheidung im Bereich zwischen 200 und 450°C und der Druck im Bereich von 60 bis 1350 Pa gehalten wird.

4. Verfahren nach Anspruch 1 bis 3, dadurch gekennzeichnet, daß das Substrat (7) über die Hochfrequenzspule (5) erwärmt wird.

5. Verfahren nach Anspruch 1 bis 4, dadurch gekennzeichnet, daß als Ausgangsmaterialien

BAD ORIGINAL

die Halogenide von Aluminium, Molybdän, Wolfram, Niob, Tantal, Gold und Silizium und die Halogenwasserstoffverbindungen von Silizium verwendet werden.

6. Verfahren nach Anspruch 1 bis 5, dadurch gekennzeichnet, daß als Substrate (7) strukturierte, teilweise oder ganz mit Siliziumoxid ($SiO_2$), Siliziumnitrid oder mit einem Kunststofflack versehene Siliziumkristallscheiben verwendet werden.

7. Verfahren nach Anspruch 1 bis 5, dadurch gekennzeichnet, daß als Substrate (7) keramische oder magnetische Werkstoff- oder Kunststoffteile, beispielsweise Polyimidfolien, verwendet werden.

8. Verfahren nach Anspruch 1 bis 7, dadurch gekennzeichnet, daß das Reaktionsgas (1) zusätzlich Wasserstoff enthält.

9. Verfahren nach Anspruch 1 bis 7, dadurch gekennzeichnet, daß als Trägergas für die Metallverbindung ein Inertgas verwendet wird.

10. Verwendung des Verfahrens nach Anspruch 1 bis 9 zur Herstellung von Mehrlagenverdrahtungen bei integrierten Halbleiterschaltungen, von Kontaktleiterbahnen für RC-Netzwerke, von Elektrodenschichten auf Dünnschichtdielektrikas, von Metallisierungen von Kunststoffteilen und zur Herstellung von Reflektor- und Absorberschichten.

BAD ORIGINAL

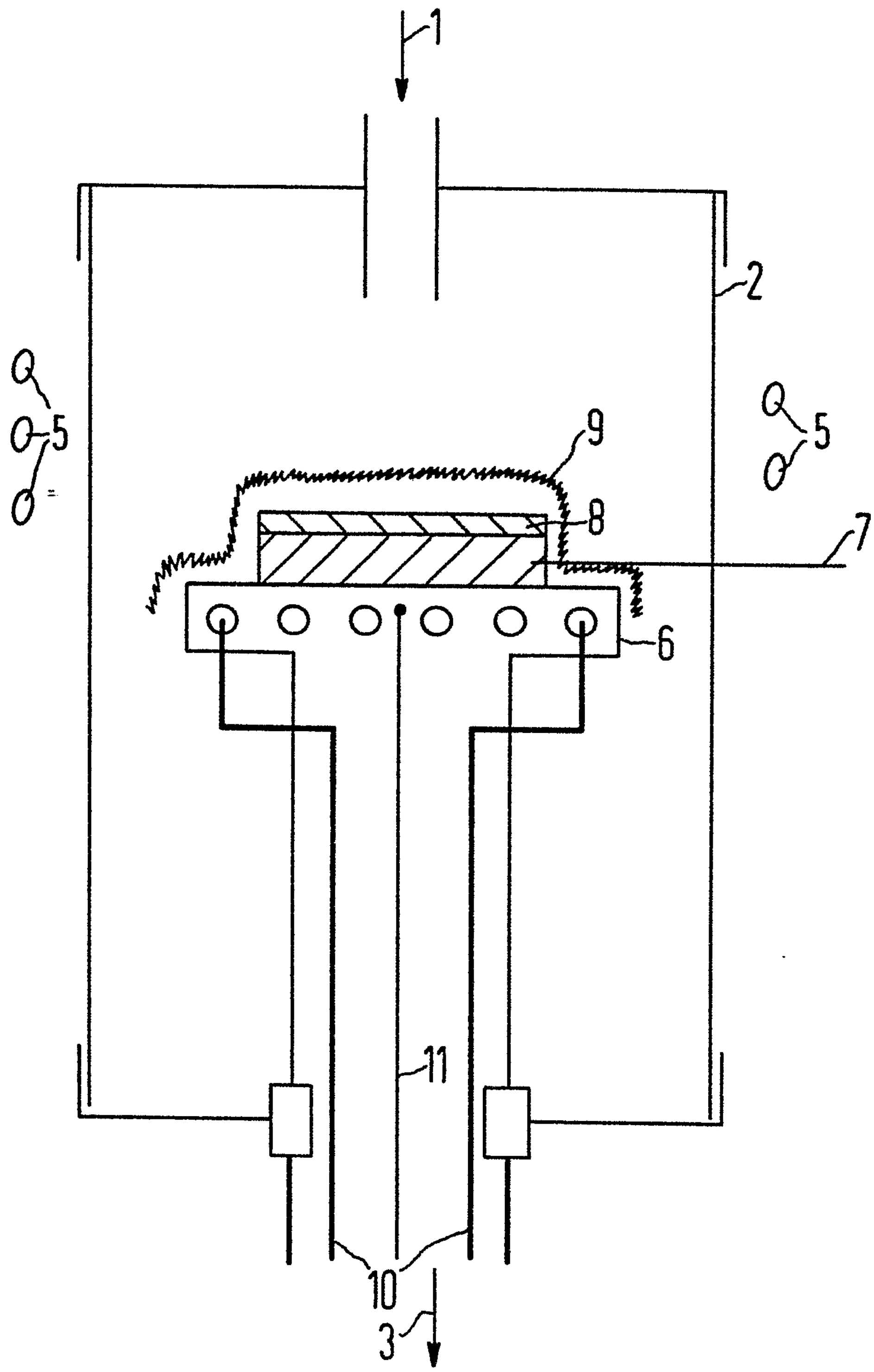
1
2
5
5
9
8
7
6
11
10
3